# EUROPÄISCHE PATENTSCHRIFT

(11) **EP 1 515 976 B1**
(45) Veröffentlichungstag und Bekanntmachung des Hinweises auf die Patenterteilung: **17.05.2006**
(21) Anmeldenummer: 03732539.6
(22) Anmeldetag: 05.06.2003
(51) Int. Cl.: C07F 1/08

(54) **DIKUPFER(I)OXALAT-KOMPLEXE ALS PRECURSOR-SUBSTANZEN ZUR METALLISCHEN KUPFERABSCHEIDUNG**
DICOPPER(I)OXALATE COMPLEXES FOR USE AS PRECURSOR SUBSTANCES IN METALLIC COPPER DEPOSITION
COMPLEXES OXALATE DE DICUIVRE(I) UTILISES EN TANT QUE SUBSTANCES PRECURSEURS POUR DEPOSER DU CUIVRE METALLIQUE

(30) Priorität: 24.06.2002 DE 10228050
(43) Veröffentlichungstag der Anmeldung: 23.03.2005
(73) Patentinhaber: BASF Aktiengesellschaft, 67056 Ludwigshafen (DE)
(72) Erfinder: KÖHLER, Katrin, 37073 Göttingen (DE); MEYER, Franc, 37073 Göttingen (DE)
(86) Internationale Anmeldenummer: PCT/EP2003/005897
(87) Internationale Veröffentlichungsnummer: WO 2004/000850

(56) Entgegenhaltungen:
- WO-A-00/63461
- US-A- 4 387 055
- DATABASE CA [Online] CHEMICAL ABSTRACTS SERVICE, COLUMBUS, OHIO, US; DIEZ, JOSEFINA ET AL: "Preparation of new mono and polynuclear bis(triphenylphosphine) copper(I) derivatives containing mono and bidentate N-heterocycles, 8-hydroxyquinoline and oxalate ligands" retrieved from STN Database accession no. 108:178938 XP002253106 & POLYHEDRON (1988), 7(1), 37-42 ,

## Beschreibung

Die Erfindung betrifft Dikupfer(I)oxalat-Komplexe stabilisiert durch neutrale Lewis-Basen-Bausteine und deren Verwendung als Precursor für die Abscheidung von metallischem Kupfer. Als neutrale Lewis-Basen werden Alkine oder Alkene, welche mindestens eine Silyl- oder Estergruppe enthalten, oder Nitrile, gesättigte und ungesättigte Stickstoff-Liganden, Phosphite, Trialkylphosphine, sauerstoff- und schwefelhaltige Liganden verwendet.

### 1. Stand der Technik und Aufgabe der Erfindung

Zur Abscheidung dünner Kupferfilme auf Substraten sind inzwischen viele Kupfer-organische Precursor bekannt. Dabei haben sich als vielversprechende Substanzen Kupfer-Verbindungen in der Oxidationsstufe +1 erwiesen, die einen β-Diketonat-Liganden und eine neutrale Lewis-Base L wie zum Beispiel ein Alken oder ein Alkin enthalten. Derartige Komplexe und deren Verwendung als Precursor im CVD-Prozeß (Chemical Vapor Deposition) sind zum Beispiel in US 5,220,044, WO 00/71550, WO 00/17278, US 6,130,345 oder in Chem. Mater. **2001,** *13,* 3993; Inorg. Chem. **2001,** *40*, 6167; Chem. Mater. **1992,** *4,* 365; Organometallics **2001,** *20,* 4001 beschrieben. Bevorzugt werden Fluorhaltige β-Diketonat-Liganden wie zum Beispiel Hexafluoroacetylacetonat eingesetzt, da die dazu korrespondierenden Kupfer(I)-Komplexe eine viel höhere thermische Stabilität und eine höhere Flüchtigkeit aufweisen als ihre Fluor-freien Analoga. Fluor-freie Kupfer(I)-β-diketonat-Komplexe wie zum Beispiel Alkin-stabilisierte Kupfer(I)acetylacetonate sind extrem Sauerstoff-empfindlich, zersetzen sich bereits bei 0°C (Chem. Ber. **1995,** *128,* 525) und sind damit nicht mehr als Precursor für den CVD-Prozeß geeignet. Die Abscheidung der Kupferschicht erfolgt in einer thermisch induzierten Disproportionierung gemäß der nachfolgenden Gleichung:

2 LCu^{I}(β-diketonat) → Cu⁰ + Cu^{II}(β-diketonat)₂ + 2 L

Das entstehende Cu^{II}(β-diketonat)₂ und die Lewis-Base L sind unter den im CVD-Prozeß verwendeten Bedingungen flüchtig und können somit aus dem System entfernt werden. Zurück bleibt idealerweise ein hochreiner Kupferfilm. In dieser Reaktion können jedoch nur 50 % des eingesetzten Kupfer(I)-Precursors in Kupfer(0) umgewandelt werden, die restlichen 50 % enden im entsprechenden Cu^{II}(β-diketonat)₂. Das gleiche Ergebnis wird bei der Verwendung von β-Ketoestern anstelle von β-Diketonen erhalten, wie zum Beispiel in WO 00/08225 oder in US 5,441,766 beschrieben. Als nachteilig hat sich jedoch bei Verwendung von Fluor-haltigen Kupfer(I)-Precursor erwiesen, dass die Haftung der Kupferfilme auf verschiedenen Substratoberflächen nicht optimal ist, was wahrscheinlich auf die van der Waals Kräfte der Fluoratome im Precursor-Molekül und damit auf abstoßende Wechselwirkungen zurückgeführt werden kann. Zudem besteht in der Mikroelektronic die Gefahr der Kontamination des Wafers speziell des Siliciums mit Fluor, was zur Unbrauchbarkeit des Wafers führt.

Einen vollständigen Umsatz an Kupfer wird mit Lewis-Basen-stabilisierten Kupfer(I)alkoxiden der Formel LCu^{I}OR (EP 0468396) und mit Lewis-Basen-stabilisierten Kupfer(I)cyclopentadienylen der Formel LCu^{I}(η⁵-C₅R₅), beschrieben in EP 0297348 und DE 4124686, erreicht. Zum Teil sind die Beispiele in den genannten Patenten sogar Fluor-frei und bei 25 °C stabil. Da jedoch die thermischen Zersetzungreaktionen in diesen Fällen nicht definiert verlaufen, werden in den Zersetzungsreaktionen radikalische Spezies gebildet, die leider zu verunreinigten Kupferfilmen (Sauerstoff ca. 5 %, Kohlenstoff ca. 1 %) führen (MRS Bulletin/August 1994, 41; Chem.Mater. **1992**, *4*, 577).

Aufgabe der vorliegenden Erfindung war es daher, Fluor-freie, einfach und kostengünstig herstellbare Kupfer(I)-Precursor für die Abscheidung von metallischem Kupfer zur Verfügung zu stellen, die thermisch und möglichst gegenüber Luft stabil sind, sich thermisch in einer definierten Zersetzungsreaktion im Temperaturbereich von ca. 50 - 400 °C unter Bildung definierter molekularer, Kupfer-freier, ungiftiger und möglichst gasförmiger Nebenprodukte vollständig zu metallischen Kupferfilmen umsetzen lassen. Weitere Aufgaben der vorliegenden Erfindung bestehen darin, neben einem einfach und kostengünstig durchführbaren Verfahren zur Herstellung der erfindungsgemäßen Precursor-Substanzen auch ein geeignetes Verfahren zur Herstellung dünner hochreiner Kupferfilme oder -schichten mit Hilfe dieser Precursor zur Verfügung zu stellen und somit auch verbesserte hochreine dünne Kupferschichten.

Die Lösung der Aufgabe erfolgt durch Verbindungen der allgemeinen Formel (I) 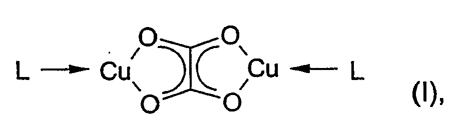 worin Kupfer in der Oxidationsstufe +1 vorliegt, und
- L: R-C≡C-R' mit mindestens einer Silyl- oder Estergruppe, R'HC=CHR mit mindestens einer Silyl- oder Estergruppe, R'₃Si-C≡C-R', R'₃N, R'₂N(CH₂)ₙNR'₂, substituiertes oder unsubstituiertes 2,2'-Bipyridin, 1,10-Phenanthrolin, P(OR')₃, P(Alkyl)₃, R'-O-R', R'-O(CH₂)ₙO-R', R'-S-R',R'-S(CH₂)ₙS-R' oder ein Nitril aus der Gruppe CH₃-C≡N, ^{t}Bu-C≡N, C₄H₉C≡N, Ph-C≡N
bedeutet
mit
- R: A, Aryl, Alkylaryl oder Alkinyl mit mindestens einer SiR'₃₋oder COOR'-Gruppe und
- R': R, H, A, Aryl, Alkylaryl oder Alkinyl,
wobei L, R und R' jeweils unabhängig voneinander in verschiedenen Positionen des Moleküls gleiche oder verschiedene Bedeutungen annehmen können,
und
- A: geradkettig oder verzweigtes C1-C30-Alkyl, C3-C30-Cycloalkyle, geradkettig oder verzweigtes C2-C30-Alkenyl, geradkettig oder verzweigtes C3-C30-Cycloalkenyl
- Aryl: C6-C10-Aryle Alkylaryle
- Alkylaryl: C7-C18-Alkylaryle
- Alkinyl: geradkettig oder verzweigtes C2-C30-Alkinyl
bedeuten.

Erfindungsgemäße Verbindungen sind daher auch Verbindungen der allgemeinen Formel (I), worin
- A: geradkettiges oder verzweigtes C1-C9-Alkyl, geradketti ges oder verzweigtes C3-C9-Cycloalkyl, geradkettiges oder verzweigtes C2-C9-Alkenyl, geradkettiges oder verzweigtes C3-C9-Cycloalkenyl
- Aryl: Phenyl, Naphthyl,
- Alkylaryl: Toluyl oder Mesityl,
- Alkinyl: geradkettige oder verzweigte C2-C9-Alkinyle
bedeuten
und L, R und R' jeweils unabhängig voneinander in verschiedenen Positionen des Moleküls gleiche oder verschiedene Bedeutungen annehmen können.

Untergruppen bilden Verbindungen der allgemeinen Formel (I), worin
**I.**
   - A: geradkettige oder verzweigte C1-C4-Alkyle aus der Gruppe Methyl, Ethyl, n- und i-Propyl oder n-, i- und tert-Butyl, C3-C6-Cycloalkyle aus der Gruppe Cyclopropyl, Cyclobutyl, Cyclopentyl und Cyclohexyl, geradkettiges oder verzweigtes C2-C6-Alkenyle aus der Gruppe Vinyl, Propenyl, Butenyl, Pentenyl oder Hexenyl, C3-C6-Cycloalkenyle aus der Gruppe Cyclopropenyl, Cyclobutenyl, Cyclopentenyl, Cyclopentadienyl und Methylcyclopentadienyl
   - Aryl: Phenyl, Naphthyl,
   - Alkylaryl: Toluyl oder Mesityl,
   - Alkinyl: geradkettige oder verzweigte -C2-C6-Alkinyle aus der Gruppe Ethinyl, Propinyl, Butinyl, Pentinyl oder Hexinyl
   bedeuten
   und R und R' jeweils unabhängig voneinander in verschiedenen Positionen des Moleküls gleiche oder verschiedene Bedeutungen annehmen können,
   oder
**II.**
   worin L
   R-C≡C-R' oder R'HC=CHR mit jeweils mindestens einer Silyl- oder Estergruppe bedeutet, und die Reste R und R' die in Anspruch 1 gegebenen Bedeutungen haben,
   oder
**III.**
   worin L R'₃Si-C≡C-R' bedeutet
   mit
   - R': SiMe₃, CH₃, C₂H₅, C₃H₇, C₄H₉, Phenyl, COOMe, COOEt,
   oder
**IV.**
   worin L ein Alkin ist, ausgewählt aus der Gruppe Me₃Si-C≡C-SiMe₃, Me₃Si-C≡C-ⁿBu, MeOOe-C≡C-COOMe, EtOOC-C≡C-COOEt und Me₃Si-C≡C-R', worin R' CH₃, C₂H₅, C₃H₇, Phenyl, COOMe oder COOEt bedeutet,
   oder
**V.**
   worin **L** ein Alken ist ausgewählt aus der Gruppe H₂C=CHSiMe₃, H₂C=CHCOOCH₃, H₂C=CHCOOC₂H₅ und H₂C=CHSiR'₃, worin R' unabhängig voneinander CH₃, C₂H₅, C₃H₇, C₄H₉, HC=CH₂, Phenyl bedeutet,
   oder
**VI.**
   worin L eine Verbindung ist, ausgewählt aus der Gruppe CH₃-C≡N, ^{t}Bu C≡N, C₄H₉C≡N, Ph-C≡N; N(CH₃)₃, N(C₂H₅)₃, H₂N-(CH₂)₂-NH₂, (CH₃)₂N-(CH₂)₂-N(CH₃)₂, (C₂H₅)₂N-(CH₂)₂-N(C₂H₅)₂, H₂N-(CH₂)₄-NH₂, (CH₃)₂N-(CH₂)₄-N(CH₃)₂, (C₂H₅)₂N-(CH₂)₄-N(C₂H₅)₂, 2,9-Dimethyl-1,10-Phenanthrolin; P(OCH₃)₃, P(OC₂H₅)₃, P(OC₆H₁₁)₃, P(OPh)₃; P(CH₃)₃, P(C₂H₅)₃, P(C₃H₇)₃, P(C₄H₉)₃, P(C₆H₁₁)₃; C₂H₅-O-C₂H₅, CH₃-O-C₄H₉, CH₃O-(CH₂)₂-OCH₃, C₂H₅O-(CH₂)₂-OC₂H₅, CH₃-S-CH₃, C₂H₅-S-C₂H₅, C₃H₇-S-C₃H₇, Ph-S-Ph, CH₃S-(CH₂)₂-SCH₃, CH₃S-(CH₂)₃-SCH₃, C₂H₅S-(CH₂)₂-SC₂H₅ und PhS-(CH₂)₂-SPh.

Insbesondere erfolgt die Lösung der Aufgabe der vorliegenden Erfindung durch die neuen Verbindungen der allgemeinen Formel(I)
Di{[Bis(trimethylsilyl)acetylen]kupfer(I)}oxalat,
Di{[(Trimethylsilyl)(n-butyl)acetylen]kupfer(I)}oxalat,
Di[(Vinyl-t-butyldimethylsilan)kupfer(I)]oxalat und
Di[(Vinyldiethylmethylsilan)kupfer(I)]oxalat.

Die Lösung der Aufgabe der vorliegenden Erfindung erfolgt auch durch ein Verfahren zur Herstellung der Verbindungen der allgemeinen Formel (I) wie aufgeführt, indem Cu₂O mit Oxalsäure und einer Lewis-Base L in einem inerten Lösungsmittel umgesetzt wird und das hergestellte Produkt isoliert wird. Insbesondere erfolgt die Lösung der Aufgabe durch die besondere Ausgestaltung des Verfahrens, wie es durch die Ansprüche 11 bis 21 beansprucht wird.

Erfindungsgemäß werden die Verbindungen der allgemeinen Formel (I) gemäß der Ansprüche 1 bis 9 zur Herstellung von hochreinen dünnen Kupfermetallschichten verwendet.

Die Herstellung von hochreinen dünnen Kupfermetallschichten, erfolgt durch ein Verfahren, zu dessen Durchführung Verbindungen der allgemeinen Formel (I) erhitzt werden, wodurch die Lewis-Base L abgespalten und metallisches Kupfer durch Decarboxylierung abgeschieden wird.

Die Abspaltung der Lewis-Base L erfolgt in einem Temperaturbereich von ca. 50 bis ca. 200 °C. Die als zweite Reaktion erfolgende Decarboxylierung unter Bildung von metallischem Kupfer und Kohlendioxid wird in einem Temperaturbereich von ca. 150 bis 350 °C abgeschlossen.

Die abgespaltene Lewis-Base L wird recycelt und erneut in einem Verfahren zur Herstellung der Verbindungen der allgemeinen Formel (I) eingesetzt und zur Herstellung von hochreinen dünnen metallischen Kupferschichten verwendet.

Die Lösung der erfindungsgemäßen Aufgabe erfolgt somit insbesondere durch hochreine dünne metallische Kupferschichten mit verbesserten Eigenschaften, hergestellt unter Verwendung einer Verbindung der allgemeinen Formel (I) in dem erfindungsgemäßen Verfahren

### 2. Beschreibung der Erfindung

Durch die vorliegende Erfindung werden Verbindungen der allgemeinen Formel (I) 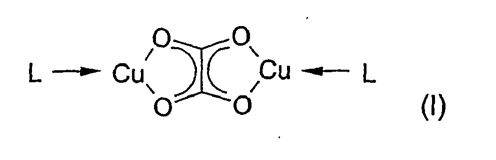 zur Verfügung gestellt, worin jeweils unabhängig von der Stellung im Komplex und voneinander

L für ein Alkin R-C≡C-R' oder Alken R'HC=CHR steht, welches mindestens eine Silyl- oder Estergruppe enthält. L kann weiter ein Nitril R'-C≡N, ein gesättigter oder ungesättigter Stickstoff-Ligand, ein Phosphit P(OR')₃, ein Trialkylphosphin P(Alkyl)₃, ein Ether R'-O-R', ein Diether, ein Thioether R'-S-R' oder ein Dithioether sein. Die Oxidationsstufe des Kupfers beträgt +1.

R kann Alkyl, Cycloalkyl, Alkenyl, Cycloalkenyl, Aryl, Alkylaryl oder Alkinyl mit mindestens einer SiR'₃ oder COOR' Gruppe sein.

R' kann unabhängig voneinander R oder H, Alkyl, Cycloalkyl, Alkenyl, Cycloalkenyl, Aryl, Alkylaryl oder Alkinyl sein.

Die Herstellung der Verbindung der allgemeinen Formel (I) erfolgt durch Umsetzung von Cu₂O, Oxalsäure und dem neutralen Liganden L oder den zwei verschiedenen neutralen Liganden in einem inerten aprotischen organischen Lösungsmittel. Die Verbindungen der allgemeinen Formel (I) lassen sich als Temperatur-stabile Substanzen rein isolieren. Zudem zeichnen sich die erhaltenen Substanzen durch eine überraschend und ungewöhnlich hohe Oxidationsbeständigkeit aus, sie können ohne Probleme an der Luft gehandhabt werden, was die nachfolgende Verwendung der Substanzen als Precursor zur Abscheidung von metallischem Kupfer enorm erleichtert.

Erhitzt man die Verbindungen der allgemeinen Formel (I), so bleibt ein hochreiner Kupferspiegel zurück; alle Nebenprodukte sind flüchtig und können somit sehr einfach vom Reaktionsort entfernt werden. Die thermische Zersetzung läuft nach der folgenden Gleichung ab:

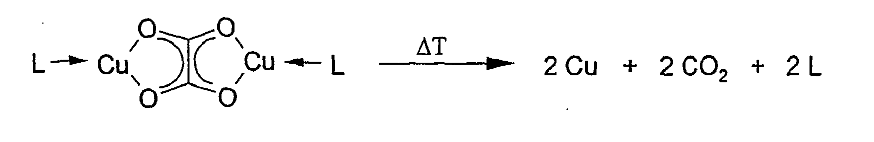

Als Reaktionsprodukte entstehen neben metallischem Kupfer nur Kohlendioxid und die Lewis-Base L, die regeneriert und wiederverwendet werden kann.

Verwenden lassen sich die Verbindungen der allgemeinen Formel (I) als Precursor zur Abscheidung von metallischem Kupfer. Die Abscheidung kann aus der Gasphase oder aus einer Lösung aus Precursor und einem geeigneten Lösungsmittel oder aus dem festen Zustand des Precursor durch Kontakt des Precursors mit einem erhitzten Substrat erfolgen. Vorteilhaft im Vergleich zum Stand der Technik ist, dass erstmals Kupfer(I)-Precursor zugänglich sind, mit denen sich zu 100 % metallisches Kupfer in einer definierten Radikal-freien Zersetzungsreaktion unter Bildung hochreiner Kupferfilme abscheiden lassen. Damit läßt sich die Ausbeute an abgeschiedenem metallischen Kupfer von 50 auf 100 % im Vergleich zum Stand der Technik erhöhen. Die hohe Stabilität und Unempfindlichkeit der Verbindungen insbesondere die hohe Oxidationsstabilität vereinfacht das Handling der Verbindungen im Verfahren zur Abscheidung von metallischem Kupfer enorm und wirkt sich somit kostengünstig auf den Abscheideprozeß aus.

Die Vorteile der Verbindungen der allgemeinen Formel (I) im Vergleich zu der nach dem Stand der Technik verwendeten Substanz (CupraSelect®) sind somit: bessere physikalische Eigenschaften wie höhere thermische Beständigkeit, bessere chemische Eigenschaften wie höhere Oxidationsstabilität, einfachere Handhabung, kostengünstigere Synthese aufgrund des viel kostengünstigeren Eduktes Oxalsäure im Vergleich zu Hexafluoroacetylaceton, doppelt so hohe Ausbeute an metallischem Kupfer im Abscheideprozeß, Kupfer-freie und ungiftige Nebenprodukte, weniger Nebenprodukte und damit eine geringere Umweltbelastung. Zudem sind keine Fluoratome in den Verbindungen enthalten, die zur Fluor-Kontamination und damit zur Unbrauchbarkeit von Wafern führen können.

Insgesamt ist damit die Synthese der erfindungsgemäßen Kupfer(I)-Precursor einfacher und kostengünstiger als die des kommerziell erhältlichen Kupfer(I)-Precursors CupraSelect®, wobei es sich um (Trimethyl-vinylsilan)kupfer(I)hexafluoroacetylacetonat handelt. Gleichzeitig kann durch die erfindungsgemäßen Precursor sowohl die Qualität der Kupferbeschichtungen erhöht werden und das Verfahren umweltfreundlicher gestaltet werden.

### 3. Ausführliche Beschreibung der Erfindung

Erfindungsgemäße Verbindungen der allgemeinen Formel (I) enthalten ein Oxalat-Dianion und zwei Kupfer-Zentren in der Oxidationsstufe +1, wobei das Oxalat-Dianion als Brücke in einem µ-1,2,3,4-Modus an die beiden Kupfer(I)-Zentren gebunden ist. Stabilisiert wird der Dikupfer(I)oxalat-Baustein CuO₂C₂O₂Cu durch Koordination von neutralen Liganden L an jeweils ein Kupfer(I)-Zentrum, vorzugsweise zwei gleichen Liganden L, so dass beide Kupfer(I)-Zentren mindestens eine pseudotrigonal-planare, gegebenenfalls auch eine tetraedrische Umgebung aufweisen. Die im Komplex enthaltenen Kupferatome können an zwei unterschiedliche Liganden L gebunden sein. Im folgenden wird zur Vereinfachung allgemein von dem Liganden oder der Lewis-Base L gesprochen, obwohl darunter auch zwei verschiedene Liganden oder Lewis-Basen L verstanden werden können.

L steht für ein Alkin R-C≡C-R' oder Alken R'HC=CHR, welches mindestens eine Silyl- oder Estergruppe enthält. L kann weiter ein Nitril R'-C≡N, ein gesättigter oder ungesättigter Stickstoff-Ligand wie zum Beispiel R'₃N, R'₂N(CH₂)ₙNR'₂, substituiertes oder unsubstituiertes 2,2'-Bipyridin bzw. 1,10-Phenanthrolin, ein Phosphit P(OR')₃, ein Alkylphosphin P(Alkyl)₃, ein Ether R'-O-R', ein Diether, ein Thioether R'-S-R' oder ein Dithioether sein. R wiederum kann Alkyl, Cycloalkyl, Alkenyl, Cycloalkenyl, Aryl, Alkylaryle oder Alkinyl mit mindestens einer SiR'₃ oder COOR' Gruppe sein. R' kann unabhängig voneinander R oder H, Alkyl, Cycloalkyl, Alkenyl, Cycloalkenyl, Aryl, Alkylaryl oder Alkinyl sein.

Alkyl-Gruppen können geradkettig oder verzweigte C1-C30-Alkyle sein, vorzugsweise geradkettige oder verzweigte C1-C9-Alkyle, besonders bevorzugt geradkettige oder verzweigte C1-C4-Alkyle aus der Gruppe Methyl, Ethyl, n- und i-Propyl oder n-, i- und tert-Butyl. CycloalkylGruppen können geradkettig oder verzweigte C3-C30-Cycloalkyle sein, vorzugsweise C3-C9-Cycloalkyle, besonders bevorzugt C3-C6-Cycloalkyle aus der Gruppe Cyclopropyl, Cyclobutyl, Cyclopentyl und Cyclohexyl.

Alkenyl-Gruppen können geradkettig oder verzweigte C2-C30-Alkenyle sein, vorzugsweise geradkettige oder verzweigte C2-C9-Alkenyle, besonders bevorzugt geradkettige oder verzweigte C2-C6-Alkenyle aus der Gruppe Vinyl, Propenyl, Butenyl, Pentenyl oder Hexenyl. Cycloalkenyl-Gruppen können geradkettig oder verzweigte C3-C30-Cycloalkenyle sein, vorzugsweise C3-C9-Cycloalkenyle, besonders bevorzugt C3-C6-Cycloalkenyle aus der Gruppe Cyclopropenyl, Cyclobutenyl, Cyclopentenyl, Cyclopentadienyl und Methylcyclopentadienyl.

Arylgruppen können C6-C10-Aryle sein, vorzugsweise Phenyl oder Naphthyl. Alkylaryle können C7-C18-Alkylaryle sein, vorzugsweise Toluyl oder Mesityl.

Alkinyl-Gruppen können geradkettig oder verzweigte C2-C30-Alkinyle sein, vorzugsweise geradkettige oder verzweigte C2-C9-Alkinyle, besonders bevorzugt geradkettige oder verzweigte C2-C6-Alkinyle aus der Gruppe Ethinyl, Propinyl, Butinyl, Pentinyl oder Hexinyl.

Als neutrale Lewis-Basen eignen sich besonders gut Alkine der Formel R-C≡C-R' und Alkene der Formel R'HC=CHR, welche mindestens eine Silyl- oder Estergruppe enthalten. Vorzugsweise werden Alkine aus der Gruppe R'₃Si-C≡C-R' eingesetzt und besonders gute Ergebnisse werden mit den Alkinen Me₃Si-C≡C-R' (R' = SiMe₃, CH₃, C₂H₅, C₃H₇, C₄H₉, Phenyl, COOMe, COOEt) und mit den Alkinen MeOOC-C≡C-COOMe und EtOOC-C≡C-COOEt erhalten. Vorzugsweise werden Alkene aus der Gruppe R'HC=CHR eingesetzt und besonders gute Eigenschaften werden mit den Alkenen H₂C=CHSiMe₃, H₂C=CHSiR'₃, in denen R' unabhängig voneinander CH₃, C₂H₅, C₃H₇, C₄H₉, HC=CH₂, Phenyl sein kann, erhalten und mit den Alkenen H₂C=CHCOOCH₃ und H₂C=CHCOOC₂H₅. Besonders gute Ergebnisse werden mit den Alkinen Me₃Si-C≡C-SiMe₃, Me₃Si-C≡C-ⁿBu und den Alkenen H₂C=CHSiEt₂Me, H₂C=CHSiMe₂^{t}Bu erhalten.

Weiter sind als neutrale Lewis-Basen geeignet: Nitrile R'C≡N zum Beispiel CH₃-C≡N, ^{t}Bu C≡N, C₄H₉C≡N oder Ph-C≡N; gesättigte oder ungesättigte Stickstoff-Liganden R'₃N wie zum Beispiel N(CH₃)₃, N(C₂H₅)₃ oder R'₂N(CH₂)ₙNR'₂ wie zum Beispiel H₂N-(CH₂)₂-NH₂, (CH₃)₂N-(CH₂)₂₋N(CH₃)₂, (C₂H₅)₂N-(CH₂)₂-N(C₂H₅)₂, H₂N-(CH₂)₄-NH₂, (CH₃)₂N-(CH₂)₄₋N(CH₃)₂, (C₂H₅)₂N-(CH₂)₄-N(C₂H₅)₂ oder substituiertes oder unsubstituiertes 2,2'-Bipyridin bzw. 1,10-Phenanthrolin, 2,9-Dimethyl-1,10-Phenanthrolin; Phosphite der Formel P(OR')₃ zum Beispiel P(OCH₃)₃, P(OC₂H₅)₃, P(OC₆H₁₁)₃, P(OPh)₃; Trialkylphosphine der Formel PR'₃ zum Beispiel P(CH₃)₃, P(C₂H₅)₃, P(C₃H₇)₃, P(C₄H₉)₃, P(C₆H₁₁)₃; Ether der Formel R'-O-R' und R'O-(CR'₂)ₙ-OR' zum Beispiel C₂H₅-O-C₂H₅, CH₃-O-C₄H₉, CH₃O-(CH₂)₂-OCH₃, C₂H₅O-(CH₂)₂-OC₂H₅, Thioether der Formel R'-S-R' und R'S-(CR'₂)ₙ-SR' zum Beispiel CH₃-S-CH₃, C₂H₅-S-C₂H₅, C₃H₇-S-C₃H₇, Ph-S-Ph, CH₃S-(CH₂)₂-SCH₃, CH₃S-(CH₂)₃-SCH₃, C₂H₅S-(CH₂)₂-SC₂H₅, PhS-(CH₂)₂-SPh.

Die Herstellung der Verbindung der allgemeinen Formel (I) erfolgt durch Umsetzung von Cu₂O, Oxalsäure und der Lewis-Base L unter Schutzgasatmosphäre in einem inerten aprotischen organischen Lösungsmittel. Als Lewis-Base L können zu diesem Zweck zwei verschiedene Lewis-Basen L im äquimolaren Verhältnis eingesetzt werden. Die Reihenfolge der Zugabe der Komponenten kann beliebig gewählt werden. Vorzugsweise werden, wenn als Lewis-Base L ein Gemisch aus zwei entsprechenden Verbindungen eingesetzt werden soll, beide Verbindungen gleichzeitig zu der Reaktionsmischung hinzugefügt oder vor der Zugabe miteinander vermischt werden. Die Ausgangsverbindungen können in einem geeigneten Lösungsmittel vorgelöst bzw. suspendiert oder ohne Lösungsmittel als Feststoff bzw. Flüssigkeit zugegeben werden. Als geeignete Lösungsmittel zur Durchführung der Reaktion können inerte aprotische Lösungsmittel wie offenkettige oder zyklische aliphatische und aromatische Kohlenwasserstoffe, die teilweise halogeniert sein können, oder Ether und zyklische Ether verwendet werden. Besonders bevorzugt ist die Verwendung von Pentan, Hexan, Heptan, Cyclohexan, Toluol, Methylenchlorid, Trichlormethan, Chlorbenzol, Diethylether oder Tetrahydrofuran. Als Schutzgasatmosphäre können Stickstoff oder Argon dienen. Das stöchiometrische Verhältnis der Edukte Cu₂O, Oxalsäure und der Lewis-Base L liegt zwischen 1:1:2 und 1:1:4, vorzugsweise zwischen 1:1:2 und 1:1:3 und besonders bevorzugt bei 1:1:2. Die Lewis-Base L sollte nicht im Unterschuß bezüglich Oxalsäure und Cu₂O zugegeben werden. Die Reaktion kann in einem Temperaturbereich von -30 bis + 100 °C, vorzugsweise von 0 bis 50 °C und ganz bevorzugt zwischen 20 und 40 °C erfolgen. Die höchsten Ausbeuten werden bei Raumtemperatur erhalten. Die Reaktionszeit beträgt zwischen 1 und 24 Stunden, vorzugsweise zwischen 2 und 8 Stunden und ganz bevorzugt zwischen 3 und 6 Stunden. Die Reaktionslösung verändert sich beginnend von einer roten Suspension hin zu einer farblosen oder bräunlichen Lösung oder Suspension je nach Art des entstehenden Komplexes. Die unlöslichen Bestandteile werden abgetrennt. Dieses kann durch Filtration, Zentrifugieren oder andere dem Fachmann bekannte Methoden erfolgen. Man erhält eine klare farblose, gelbe oder rote Lösung je nach Art der eingesetzten Lewis-Base L. Anschließend werden die Verbindungen der allgemeinen Formel (I) isoliert. Dieses kann nach Entfernung des Lösungsmittels nach dem Fachmann bekannten Methoden erfolgen. Gegebenenfalls erfolgt eine weitere Aufreinigung. Anstelle der mechanischen Abtrennung der Feststoffe aus dem Reaktionsgemisch durch Filtration oder andere Methoden kann auch eine Extraktion zur Abtrennung des gebildeten Produktes erfolgen. Die Verbindungen der allgemeinen Formel (I) sind, wie oben bereits beschrieben, überraschend Temperatur-stabil und lassen sich daher gut als reine Substanzen isolieren und anschließend analytisch und spektroskopisch charakterisieren.

Das thermische Verhalten der Verbindungen kann mittels TGA (thermogravimetrische Analyse) und DSC (Differential Scanning Calorimetry) untersucht untersucht werden. Durchgeführte Untersuchungen zeigten, dass die Zersetzung der erfindungsgemäßen Verbindungen in 2 Hauptstufen erfolgt:

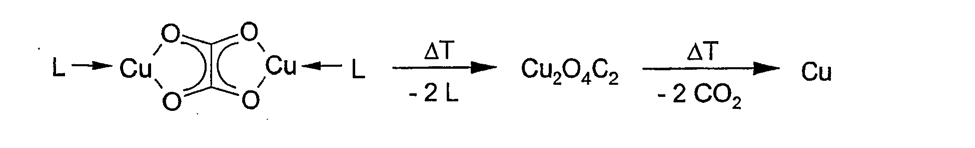

Zuerst spaltet sich die Lewis-Base L vom Kupfer(I)-Komplex ab. Diese Abspaltung kann je nach Verbindung auch stufenweise erfolgen und durch eine TGA nachgewiesen werden. In der zweiten Stufe erfolgt durch eine interne Redoxreaktion des verbliebenen Fragmentes CuO₂C₂O₂Cu die Decarboxylierung unter Bildung von metallischem Kupfer und Kohlendioxid. Die erste Stufe erfolgt je nach Precursor in einem Temperaturbereich von ca. 50 bis ca. 200 °C, die zweite ab ca. 150 und ist bei ca. 350 °C abgeschlossen. Wobei jedoch die Abspaltung der Lewis-Basen und die Decarboxylierungsreaktion beim Übergang zu höheren Temperaturen durchaus parallel ablaufen können. Der Restgehalt entspricht exakt dem Kupfer-Anteil in dem entsprechenden Kupfer(I)-Precursor, so dass die Ausbeute an metallischem Kupfer mit den Verbindungen der allgemeinen Formel (I) 100 % und damit doppelt so hoch ist wie die des Stands der Technik.

Durch diese effiziente Zersetzungsreaktion entstehen mit den Verbindungen der allgemeinen Formel (I) weniger Nebenprodukte im Vergleich zum Stand der Technik. Es bildet sich im Abscheideprozess die freie Lewis-Base L zurück, die durch entsprechende Vorrichtungen, wie Beispielsweise Kühlfallen in der Abluft, aufgefangen und wieder verwendet werden kann; als zweites Nebenprodukt entsteht Kohlendioxid. Die Nebenprodukte sind somit im Vergleich zum Stand der Technik, bei dem Kupfer(II)hexafluoroacetylacetonat und die Lewis-Base Trimethylvinylsilan als Nebenprodukte entstehen, Kupfer-frei, nicht toxisch und somit ungefährlicher. Damit ist die Umweltbelastung wesentlich geringer als die bei der Verwendung der Verbindungen des Stands der Technik.

Als thermisch stabile und am wenigstens oxidationsempfindliche Verbindung hat sich (Me₃Si-C≡C-SiMe₃)₂Cu₂O₄C₂ erwiesen. Die Verbindung ist bis 100 °C stabil und kann über Wochen an der Luft gehandhabt werden. Dieses ist im Vergleich zum Stand der Technik ein enormer Fortschritt, da das CupraSelect® sich bereits ab ca. 50 °C langsam zersetzt und die Verbindung auch an Luft schnell zu Kupfer(II) oxidiert wird. Dies ermöglicht eine sehr viel einfachere Handhabung nicht nur bei der Synthese sondern auch im Abscheideprozeß.

Die Verbindungen der allgemeinen Formel (I) lassen sich als Precursor zur metallischen Kupferabscheidung verwenden. Die Abscheidung metallischer Kupferfilme kann aus der Gasphase oderaus einer Lösung aus Precursor und einem geeigneten Lösungsmittel oder aus dem festen Zustand des Precursor durch Kontakt des Precursors mit einem erhitzten Substrat erfolgen.

Zur Veranschaulichung und zum besseren Verständnis der vorliegenden Erfindung werden im folgenden Beispiele gegeben. Diese sind jedoch aufgrund der allgemeinen Gültigkeit des beschriebenen Erfindungsprinzips nicht geeignet, den Schutzbereich der vorliegenden Anmeldung nur auf diese Beispiele zu reduzieren. Weiterhin ist der Inhalt der zitierten Patentanmeldungen als Teil der Offenbarung der vorliegenden Erfindung, die der Beschreibung zugrunde liegt, anzusehen.

### 4. Beipsiele

### Beispiel 1

### Di{[Bis(trimethylsilyl)acetylen]kupfer(l)}oxalat

Zu einer Suspension von 3.4 g Cu₂O in 30 ml Methylenchlorid werden in einer Inertgasatmosphäre 8 g Me₃SiC≡CSiMe₃ und 2.14 g Oxalsäure gegeben und 4 Stunden bei Raumtemperatur gerührt. Zur Abtrennung unlöslicher Rückstände wird die Lösung über eine Fritte mit Kieselgel gegeben und der Rückstand auf der Fritte zweimal mit Methylenchlorid gewaschen. Die farblose Lösung wird eingeengt, und bei -30°C werden farblose Kristalle von (Me₃SiC≡CSiMe₃)₂Cu₂O₄C₂ erhalten.

C₁₈H₃₆Cu₂O₄Si₄ (555.92 g/mol). Analyse [%]: berechnet: C 38.9, H 6.5, gefunden: C 38.7, H 6.6. IR (KBr) [cm⁻¹]: ν_{C≡C} 1935, ν_{CO2} 1642, 1354, 1309. ¹H-NMR (CDCl₃) [ppm]: 0.30 (s, 36 H, SiMe₃). ¹³C-NMR (CDCl₃) [ppm]: 0.0 (SiMe₃), 114.2 (C≡C), 171.8 (CO₂). MS (*m*/*z* (%)): 788 (25) [M + Cu(Me₃SiC≡CSiMe₃)]⁺, 618 (10) [M + Cu]⁺, 403 (68) [M - CuO₄C₂]⁺, 233 (100) [M - (Me₃SiC≡CSiMe₃)CuO₄C₂]⁺. TG (30-1000°C, 5°C/min) Zweistufenzerfall, 1. Stufe Temperaturbereich 100-170°C Gewichtsabnahme 65% (2 Me₃SiC≡CSiMe₃), 2. Stufe Temperaturbereich 230-290°C, Gewichtsabnahme 11 % (2 CO₂), Restgehalt 24% (2 Cu).

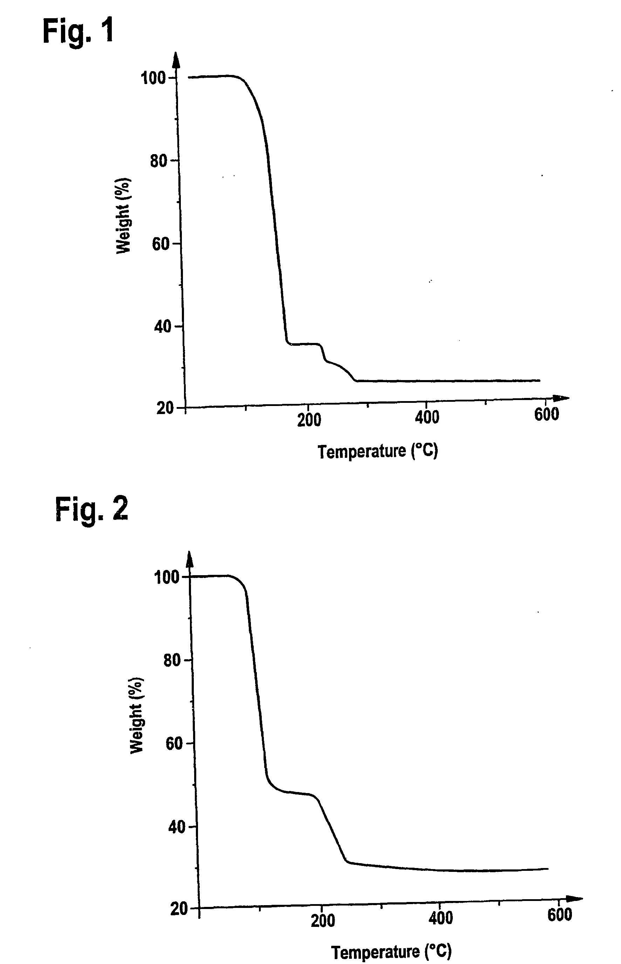

In Abb. 1 ist der Zerfall des hergestellten Di{[Bis(trimethylsilyl)acetylen]kupfer(I)}oxalats in Abhängigkeit von der Temperatur unter Abscheidung einer dünnen Kupferschicht auf einem Substrat dargestellt.

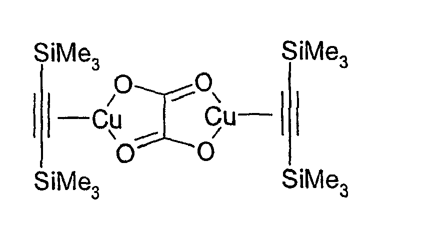

### Beispiel 2

### Di{[(Trimethylsilyl)(n-butyl)acetylen]kupfer(I)}oxalat

Zu einer Suspension von 1.8 g Cu₂O in 400 ml Methylenchlorid werden in einer Inertgasatmosphäre 5 ml Me₃SiC≡CⁿBu und 1.13 g Oxalsäure gegeben und 5 Stunden bei Raumtemperatur gerührt. Zur Abtrennung unlöslicher Rückstände wird die Lösung über eine Fritte mit Kieselgel gegeben und der Rückstand auf der Fritte zweimal mit Methylenchlorid gewaschen. Die farblose Lösung wird eingeengt, und bei -30°C werden farblose Kristalle von (Me₃SiC≡CⁿBu)₂Cu₂O₄C₂ erhalten.

C₂₀H₃₆CU₂O₄Si₂ (523.77 g/mol). IR (KBr) [cm⁻¹]: ν_{C≡C} 1986, ν_{CO2} 1643, 1355, 1311. ¹H-NMR (CDCl₃) [ppm]: 0.29 (s, 18 H, SiMe₃), 0.93 [t, ³J_{HH} = 7.0 Hz, 6 H, (CH₂)₃*CH*₃], 1.3-1.6 [m, 4 H, (CH₂)₂*CH*₂CH₃], 1.5-1.8 (m, 4 H, CH₂*CH*₂CH₂CH₃), 2.58 [t, ³J_{HH} = 7.0 Hz, 4 H, *CH*_{*2*}(CH₂)₂*CH*_{*3*}]. ¹³C-NMR (CDCl₃) [ppm]: 0.0 (SiMe₃), 13.4 [(CH₂)₃CH₃], 21.7 [(CH₂)₂CH₂CH₃], 22.5 (CH₂CH₂CH₂CH₃), 30.9 (≡CCH₂), 85.4 (≡CCH₂), 112.9 (SiC≡C), 171.4 (CO₂). MS (m/z (%)): 741 (20) [M + Cu(Me₃SiC≡CBu)]⁺, 587 (20) [M + Cu]⁺, 371 (93) [M - CuO₄C₂]⁺, 217 (100) [M - (Me₃SiC≡CBu)CuO₄C₂]⁺. TG (30-1000°C, 5°C/min) Zweistufenzerfall, 1. Stufe Temperaturbereich 70-150°C Gewichtsabnahme 53% (2 Me₃SiC≡CBu), 2. Stufe Temperaturbereich 170-300°C, Gewichtsabnahme 23% (2 CO₂), Restgehalt 24% (2 Cu).

In Abb. 2 ist der Zerfall des hergestellten Di{[(Trimethylsilyl)(n-butyl)acetylen]kupfer(I)}oxalats in Abhängigkeit von der Temperatur unter Abscheidung einer dünnen Kupferschicht auf einem Substrat dargestellt.

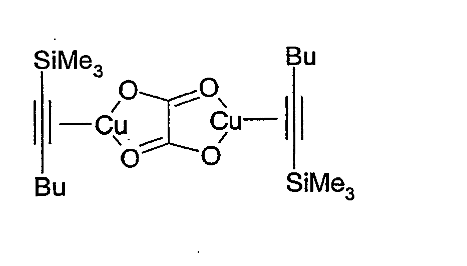

### Beispiel 3

### Di[(Vinyl-t-butyldimethylsilan)kupfer(I)]oxalat

Zu einer Suspension von 1.8 g Cu₂O in 400 ml Methylenchlorid werden in einer Inertgasatmosphäre 4.8 ml H₂C=CHSiMe₂^{t}Bu und 1.13 g Oxalsäure gegeben und 5 Stunden bei Raumtemperatur gerührt. Zur Abtrennung unlöslicher Rückstände wird die Lösung über eine Fritte mit Kieselgel gegeben und der Rückstand auf der Fritte zweimal mit Methylenchlorid gewaschen. Die farblose Lösung wird eingeengt, und bei - 30°C werden farblose Kristalle von (H₂C=CHSiMe₂^{t}Bu)₂Cu₂O₄C₂ erhalten.

C₁₈H₃₆Cu₂O₄Si₂ (499.75 g/mol). IR (KBr) [cm⁻¹]: ν_{CO2} 1647, 1344, 1312. ¹H-NMR (CDCl₃) [ppm]: 0.14 (s, 12 H, Si(CH₃)₂), 0.90 (s, 18 H, C(CH₃)₃), 4.50 (dd, Jₜᵣₐₙₛ = 18.3 Hz, J_{gem} = 2.5 Hz, 2 H, SiCH=C*H*₂), 4.78 (dd, Jₜᵣₐₙₛ = 18.3 Hz, J_{cis} = 13.3 Hz, 2 H, SiC*H*=CH₂), 4.86 (dd, J_{cis} = 13.3 Hz, J_{gem} = 2.5 Hz, 2 H, SiCH=*CH*₂). ¹³C-NMR (CDCl₃) [ppm]: -5.8 (SiMe₂), 16.8 (CMe₃), 26.2 (C*Me*₃), 91.0 (=CH₂), 97.4 (=CHSi), 171.6 (CO₂). MS (m/z (%)): 347 (62) [M - CuO₄C₂]⁺, 206 (80) [M-(H₂C=CHSiMe₂Bu)CuO₄C₂]⁺. TG (30-1000°C, 5°C/min) Dreistufenzerfall, 1. Stufe Temperaturbereich 70-130°C Gewichtsabnahme 39% (H₂C=CHSiMe₂^{t}Bu, H₂C=CMe₂), 2. Stufe Temperaturbereich 130-170°C Gewichtsabnahme 15% ( H₂C=CHSiMe₂H), 3. Stufe Temperaturbereich 170-310°C, Gewichtsabnahme 19% (2 CO₂), Restgehalt 27% (2 Cu).

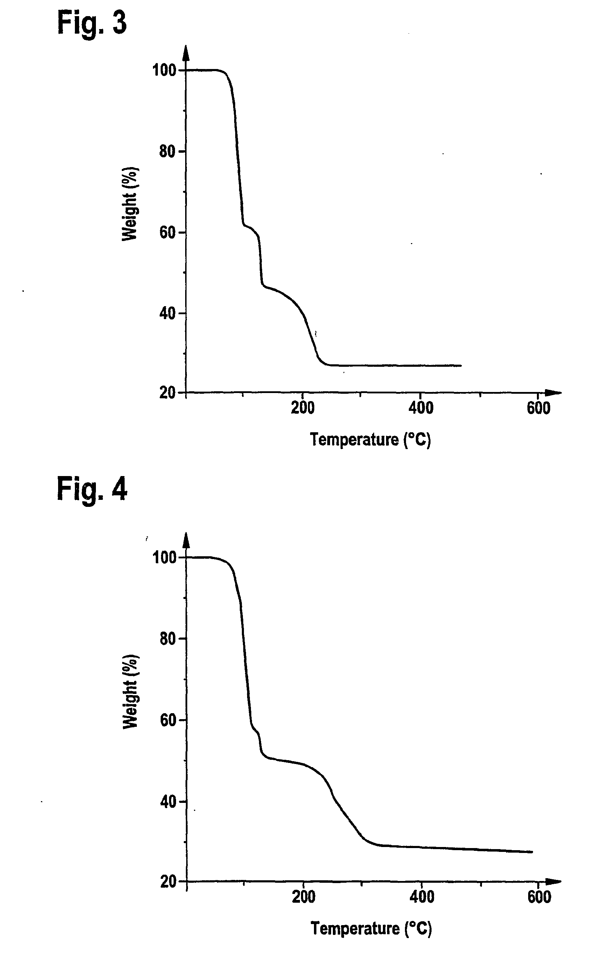

In Abb. 3 ist der Zerfall des hergestellten Di[(Vinyl-t-butyldimethylsilan)kupfer(I)]oxalats in Abhängigkeit von der Temperatur unter Abscheidung einer dünnen Kupferschicht auf einem Substrat dargestellt.

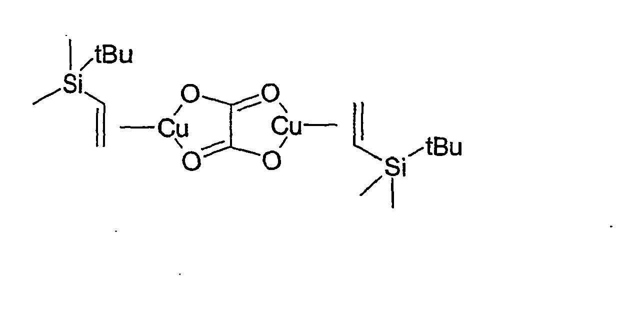

### Beispiel 4

### Di[(Vinyldiethylmethylsilan)kupfer(I)]oxalat

Zu einer Suspension von 1.8 g Cu₂O in 400 ml Methylenchlorid werden in einer Inertgasatmosphäre 4.4 ml H₂C=CHSiEt₂Me und 1.1 g Oxalsäure gegeben und 5 Stunden bei Raumtemperatur gerührt. Zur Abtrennung unlöslicher Rückstände wird die Lösung über eine Fritte mit Kieselgel gegeben und der Rückstand auf der Fritte zweimal mit Methylenchlorid gewaschen. Die farblose Lösung wird eingeengt, und bei -30°C werden farblose Kristalle von (H₂C=CHSiEt₂Me)₂Cu₂O₄C₂ erhalten.

C₁₆H₃₂Cu₂O₄Si₂ (471.70 g/mol). IR (KBr) [cm⁻¹]: ν_{C=C} 1496; ν_{CO2} 1645, 1343, 1310. ¹H-NMR (CDCl₃) [ppm]: 0.12 (s, 6 H, SiMe), 0.65 (q, 8 H, ³J = 7.8 Hz, CH₂), 0.98 (t, 12 H, ³J = 7.9 Hz, CH₃), 4.48 (dd, Jₜᵣₐₙₛ = 17.5 Hz, J_{gem} = 3.6 Hz, 2 H, SiCH=CH*H*), 4.75 (dd, Jₜᵣₐₙₛ = 17.7 Hz, J_{cis} = 13.0 Hz, 2 H, SiC*H*=CH₂), 4.81 (dd, J_{cis} = 13.0 Hz, J_{gem} = 3.5 Hz, 2 H, SiCH=CHH). ¹³C-NMR (CDCl₃) [ppm]: -5.5 (SiCH₃), 5.3 (SiCH₂CH₃), 7.3 (SiCH₂CH₃), 89.7 (H₂C=CH), 96.6 (H₂C=CH), 171.5 (COO). TG (30-1000°C, 5°C/min) Zweistufenzerfall, 1. Stufe Temperaturbereich 50-150°C Gewichtsabnahme 50% (2 H₂C=CHSiEt₂Me), 2. Stufe Temperaturbereich 150-320°C Gewichtsabnahme 23% (2 CO₂), Restgehalt 27% (2 Cu).

In Abb. 4 ist der Zerfall des hergestellten Di[(Vinyldiethylmethylsilan)kupfer(I)]oxalats in Abhängigkeit von der Temperatur unter Abscheidung einer dünnen Kupferschicht auf einem Substrat dargestellt.

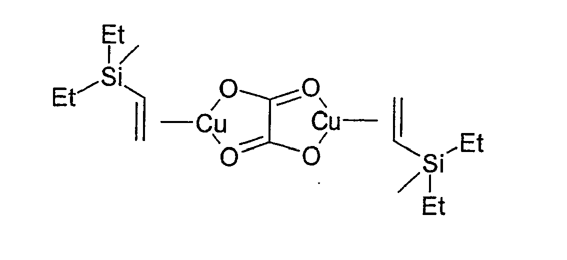

## Patentansprüche

1. Verbindungen der allgemeinen Formel (I) 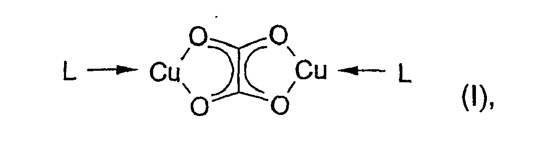 worin Kupfer die Oxidationsstufe +1aufweist, und
L R-C≡C-R' mit mindestens einer Silyl- oder Estergruppe, R'HC=CHR mit mindestens einer Silyl- oder Estergruppe, R'₃Si-C≡C-R', R'₃N, R'₂N(CH₂)ₙNR'₂, substituiertes oder unsubstituiertes 2,2'-Bipyridin, 1,10-Phenanthrolin, P(OR')₃, P(Alkyl)₃, R'-O-R', R'-O(CH₂)ₙO-R', R'-S-R',R'- S(CH₂)ₙS-R' oder ein Nitril aus der Gruppe CH₃-C≡N, ^{t}Bu-C≡N, C₄H₉C≡N und Ph-C≡N
bedeutet
mit
R A, Aryl, Alkylaryl oder Alkinyl mit mindestens einer SiR'₃₋oder COOR'-Gruppe und
R' R, H, A, Aryl, Alkylaryl oder Alkinyl,
wobei L, R und R' jeweils unabhängig voneinander in verschiedenen Positionen des Moleküls gleiche oder verschiedene Bedeutungen annehmen können,
und
A geradkettig oder verzweigtes C1-C30-Alkyl, C3-C30-Cycloalkyle, geradkettig oder verzweigtes C2-C30- Alkenyl, geradkettig oder verzweigtes C3-C30-Cycloalkenyl
Aryl C6-C10-Aryle Alkylaryle
Alkylaryl C7-C18-Alkylaryle
Alkinyl geradkettig oder verzweigtes C2-C30-Alkinyl
bedeuten.

2. Verbindungen gemäß Anspruch 1, worin
A geradkettiges oder verzweigtes C1-C9-Alkyl, geradketti ges oder verzweigtes C3-C9-Cycloalkyl, geradkettiges oder verzweigtes C2-C9-Alkenyl, geradkettiges oder verzweigtes C3-C9-Cycloalkenyl
Aryl Phenyl, Naphthyl,
Alkylaryl Toluyl oder Mesityl,
Alkinyl geradkettige oder verzweigte C2-C9-Alkinyle
bedeuten
und R und R' jeweils unabhängig voneinander in verschiedenen Positionen des Moleküls gleiche oder verschiedene Bedeutungen annehmen können.

3. Verbindungen gemäß Anspruch 1, worin
A geradkettige oder verzweigte C1-C4-Alkyle aus der Gruppe Methyl, Ethyl, n- und i-Propyl oder n-, i- und tert-Butyl, C3-C6-Cycloalkyle aus der Gruppe Cyclopropyl, Cyclobutyl, Cyclopentyl und Cyclohexyl, geradkettiges oder verzweigtes C2-C6-Alkenyle aus der Gruppe Vinyl, Propenyl, Butenyl, Pentenyl oder Hexenyl, C3-C6-Cycloalkenyle aus der Gruppe Cyclopropenyl, Cyclobu- tenyl, Cyclopentenyl, Cyclopentadienyl und Methylcyclopentadienyl
Aryl Phenyl, Naphthyl,
Alkylaryl Toluyl oder Mesityl,
Alkinyl geradkettige oder verzweigte C2-C6-Alkinyle aus der Gruppe Ethinyl, Propinyl, Butinyl, Pentinyl oder Hexinyl
bedeuten
und R und R' jeweils unabhängig voneinander in verschiedenen Positionen des Moleküls gleiche oder verschiedene Bedeutungen annehmen können.

4. Verbindungen gemäß Anspruch 1,
worin L
R-C≡C-R' oder R'HC=CHR mit jeweils mindestens einer Silyl- oder Estergruppe bedeutet, und die Reste R und R' die in Anspruch 1 gegebenen Bedeutungen haben.

5. Verbindungen gemäß Anspruch 1,
worin L
R'₃Si-C≡C-R' bedeutet
mit
R' SiMe₃, CH₃, C₂H₅, C₃H₇, C₄H₉, Phenyl, COOMe, COOEt.

6. Verbindungen gemäß Anspruch 1,
worin L ein Alkin ist, ausgewählt aus der Gruppe Me₃Si-C≡C-SiMe₃, Me₃Si-C≡C-ⁿBu, MeOOC-C≡C-COOMe, EtOOC-C≡C-COOEt und Me₃Si-C≡C-R', worin R' CH₃, C₂H₅, C₃H₇, Phenyl, COOMe oder COOEt bedeutet.

7. Verbindungen gemäß Anspruch 1,
worin L ein Alken ist ausgewählt aus der Gruppe H₂C=CHSiMe₃, H₂C=CHCOOCH₃, H₂C=CHCOOC₂H₅ und H₂C=CHSiR'₃, worin R' unabhängig voneinander CH₃, C₂H₅, C₃H₇, C₄H₉, HC=CH₂, Phenyl bedeutet.

8. Verbindungen gemäß Anspruch 1,
worin L eine Verbindung ist, ausgewählt aus der Gruppe CH₃-C≡N, ^{t}Bu C≡N, C₄H₉C≡N, Ph-C≡N; N(CH₃)₃, N(C₂H₅)₃, H₂N-(CH₂)₂-NH₂, (CH₃)₂N-(CH₂)₂-N(CH₃)₂, (C₂H₅)₂N-(CH₂)₂-N(C₂H₅)₂, H₂N-(CH₂)₄-NH₂, (CH₃)₂N-(CH₂)₄-N(CH₃)₂, (C₂H₅)₂N-(CH₂)₄-N(C₂H₅)₂, 2,9-Dimethyl-1,10-Phenanthrolin; P(OCH₃)₃, P(OC₂H₅)₃, P(OC₆H₁₁)₃, P(OPh)₃; P(CH₃)₃, P(C₂H₅)₃, P(C₃H₇)₃, P(C₄H₉)₃, P(C₆H₁₁)₃; C₂H₅-O-C₂H₅, CH₃₋O-C₄H₉, CH₃O-(CH₂)₂-OCH₃, C₂H₅O-(CH₂)₂-OC₂H₅, CH₃-S-CH₃, C₂H₅-S-C₂H₅, C₃H₇-S-C₃H₇, Ph-S-Ph, CH₃S-(CH₂)₂-SCH₃, CH₃S-(CH₂)₃-SCH₃, C₂H₅S-(CH₂)₂-SC₂H₅ und PhS-(CH₂)₂-SPh.

9. Verbindungen der allgemeinen Formel(I)
Di{[Bis(trimethylsilyl)acetylen]kupfer(I)}oxalat,
Di{[(Trimethylsilyl)(n-butyl)acetylen]kupfer(I)}oxalat,
Di[(Vinyl-t-butyldimethylsilan)kupfer(I)]oxalat,
Di[(Vinyldiethylmethylsilan)kupfer(I)]oxalat.

10. Verfahren zur Herstellung der Verbindungen der allgemeinen Formel (I) gemäß der Ansprüche 1 - 9, **dadurch gekennzeichnet, dass** Cu₂O mit Oxalsäure und einer Lewis-Base L in einem inerten Lösungsmittel umgesetzt wird und das hergestellte Produkt isoliert wird.

11. Verfahren gemäß Anspruch 10, **dadurch gekennzeichnet, dass** ein inertes aprotisches organisches Lösungsmittel verwendet wird, bei dem es sich um offenkettige oder zyklische aliphatische oder aromatische Kohlenwasserstoffe, um halogenierte aliphatische oder halogenierte aromatische Kohlenwasserstoffe oder um lineare oder cyclische Ether oder um Gemische dieser Kohlenwasserstoffe handelt.

12. Verfahren nach einem der Ansprüche 10 bis 11, **dadurch gekennzeichnet, dass** ein Lösungsmittel, ausgewählt aus der Gruppe Pentan, Hexan, Heptan, Cyclohexan, Toluol, Methylenchlorid, Trichlormethan, Chlorbenzol, Diethylether oder Tetrahydrofuran, verwendet wird.

13. Verfahren gemäß Anspruch 10, **dadurch gekennzeichnet, dass** es unter Schutzgasatmosphäre durchgeführt wird.

14. Verfahren gemäß Anspruch 13, **dadurch gekennzeichnet, dass** als Schutzgas Stickstoff oder Argon eingesetzt wird.

15. Verfahren gemäß Anspruch 10, **dadurch gekennzeichnet, dass** die Lewis-Base L im Überschuss bezogen auf das stöchiometrische Verhältnis der Edukte Cu₂O und Oxalsäure eingesetzt wird, mindestens aber im doppelten stöchiometrischen Verhältnis.

16. Verfahren gemäß einem der Ansprüche 10 und 15, **dadurch gekennzeichnet, dass** die Edukte Cu₂O, Oxalsäure und Lewis-Base L im stöchiometrischen Verhältnis 1 : 1 : 2 bis 1 : 1 : 4 eingesetzt werden.

17. Verfahren gemäß einem oder mehreren der Ansprüche 10, 15 und 16, **dadurch gekennzeichnet, dass** zwei verschiedene Lewis-Basen L in gleichen molaren Mengen eingesetzt werden.

18. Verfahren gemäß einem oder mehreren der Ansprüche 10 bis 17, **dadurch gekennzeichnet, dass** die Umsetzung innerhalb einer Reaktionszeit von 1 bis 24 Stunden in einem Temperaturbereich von - 30 bis +100 °C durchgeführt wird.

19. Verfahren gemäß einem oder mehreren der Ansprüche 10 bis 18, **dadurch gekennzeichnet, dass** bei Raumtemperatur gearbeitet wird.

20. Verfahren gemäß einem oder mehreren der Ansprüche 10 bis 19, **dadurch gekennzeichnet, dass** nach erfolgter Reaktion unlösliche Bestandteile abgetrennt werden und das Reaktionsprodukt aus der Lösung isoliert und gegebenenfalls gereinigt wird, oder dass das Reaktionsprodukt durch Extraktion vom Reaktionsgemisch abgetrennt, isoliert und gegebenenfalls gereinigt wird.

21. Verfahren gemäß einem oder mehreren der Ansprüche 10 bis 19, **dadurch gekennzeichnet, dass** unlösliche Bestandteile durch Filtration abgetrennt werden.

22. Verwendung der Verbindungen der allgemeinen Formel (I) gemäß der Ansprüche 1 bis 9 zur Herstellung von hochreinen dünnen Kupfermetallschichten.

23. Verfahren zur Herstellung von hochreinen dünnen Kupfermetallschichten, **dadurch gekennzeichnet, dass** Verbindungen der allgemeinen Formel (I) gemäß der Ansprüche 1 bis 9 erhitzt werden, wodurch die Lewis-Base L abgespalten und metallisches Kupfer durch Decarboxylierung abgeschieden wird.

24. Verfahren gemäß Anspruch 23, **dadurch gekennzeichnet, dass** die Abspaltung der Lewis-Base L in einem Temperaturbereich von 50 bis ca. 200 °C erfolgt und die Decarboxylierung unter Bildung von metallischem Kupfer in einem Temperaturbereich von 150 bis 350 °C abgeschlossen wird.

25. Verfahren gemäß der Ansprüche 23 bis 24, **dadurch gekennzeichnet, dass** die abgespaltene Lewis-Base L recycelt wird, erneut in einem Verfahren gemäß der Ansprüche 10 bis 21 eingesetzt und zur Herstellung von hochreinen dünnen metallischen Kupferschichten verwendet wird.

## Claims

1. Compounds of the general formula (I) 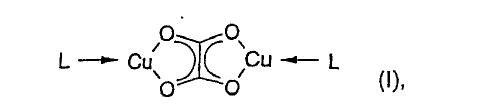 wherein copper is in the oxidation state +1 and
L is R-C≡C-R' having at least one silyl or ester group, R'HC=CHR having at least one silyl or ester group, R'₃Si-C≡C-R', R'₃N, R'₂N(CH₂)ₙNR'₂, substituted or unsubstituted 2,2'-bipyridine, 1,10-phenanthroline, P(OR')₃, P(alkyl)₃, R'-O-R', R'-O(CH₂)ₙO-R', R'-S-R',R'-S(CH₂)ₙS-R' or a nitrile from the group consisting of CH₃-C≡N, ^{t}Bu-C≡N, C₄H₉C≡N and Ph-C≡N
where
R is A, aryl, alkylaryl or alkynyl having at least one SiR'₃ or COOR' group and
R' is R, H, A, aryl, alkylaryl or alkynyl,
L, R and R' may each independently assume identical or different meanings in different positions of the molecule,
and
A is straight-chain or branched C1-C30-alkyl, C3-C30-cycloalkyls, straight-chain or branched C2-C30-alkenyl, straight-chain or branched C3-C30-cycloalkenyl
aryl is C6-C10-aryls alkylaryls
alkylaryl is C7-C18-alkylaryls
alkynyl is straight-chain or branched C2-C30-alkynyl.

2. Compounds according to claim 1 wherein
A is straight-chain or branched C1-C9-alkyl, straight-chain or branched C3-C9-cycloalkyl, straight-chain or branched C2-C9-alkenyl, straight-chain or branched C3-C9-cycloalkenyl
aryl is phenyl, naphthyl,
alkylaryl is tolyl or mesityl,
alkynyl is straight-chain or branched C2-C9-alkynyls
and
R and R' may each independently assume identical or different meanings in different positions of the molecule.

3. Compounds according to claim 1 wherein
A is straight-chain or branched C1-C4-alkyls from the group consisting of methyl, ethyl, n- and i-propyl or n-, i-and tert-butyl, C3-C6-cycloalkyls from the group consisting of cyclopropyl, cyclobutyl, cyclopentyl and cyclohexyl, straight-chain or branched C2-C6-alkenyls from the group consisting of vinyl, propenyl, butenyl, pentenyl and hexenyl, C3-C6-cycloalkenyls from the group consisting of cyclopropenyl, cyclobutenyl, cyclopentenyl, cyclopentadienyl and methylcyclopentadienyl
aryl is phenyl, naphthyl,
alkylaryl is tolyl or mesityl,
alkynyl is straight-chain or branched C2-C6-alkynyls from the group consisting of ethynyl, propynyl, butynyl, pentynyl and hexynyl
and
R and R' may each independently assume identical or different meanings in different positions of the molecule.

4. Compounds according to claim 1
wherein L is
R-C≡C-R' or R'HC=CHR each having at least one silyl or ester group and the radicals R and R' are each as defined in claim 1.

5. Compounds according to claim 1
wherein L is
R'₃Si-C≡C-R'
where
R' is SiMe₃, CH₃, C₂H₅, C₃H₇, C₄H₉, phenyl, COOMe, COOEt.

6. Compounds according to claim 1
wherein L is an alkyne selected from the group consisting of Me₃Si-C≡C-SiMe₃, Me₃Si-C≡C-ⁿBu, MeOOC-C≡C-COOMe, EtOOC-C≡C-COOEt and Me₃Si-C≡C-R',
wherein R' is CH₃, C₂H₅, C₃H₇, phenyl, COOMe or COOEt.

7. Compounds according to claim 1
wherein L is an alkene selected from the group consisting of H₂C=CHSiMe₃, H₂C=CHCOOCH₃, H₂C=CHCOOC₂H₅ and H₂C=CHSiR₃, wherein each R' is independently CH₃, C₂H₅, C₃H₇, C₄H₉, HC=CH₂, phenyl.

8. Compounds according to claim 1
wherein L is a compound selected from the group consisting of CH₃-C≡N, ^{t}Bu C≡N, C₄H₉C≡N, Ph-C≡N; N(CH₃)₃, N(C₂H₅)₃, H₂N-(CH₂)₂-NH₂, (CH₃)₂N-(CH₂)₂₋N(CH₃)₂, (C₂H₅)₂N-(CH₂)₂-N(C₂H₅)₂, H₂N-(CH₂)₄-NH₂, (CH₃)₂N-(CH₂)₄-N(CH₃)₂, (C₂H₅)₂N-(CH₂)₄-N(C₂H₅)₂, 2,9-dimethyl-1,10-phenanthroline; P(OCH₃)₃, P(OC₂H₅)₃, P (OC₆H₁₁)₃, P(OPh)₃; P (CH₃)₃, P (C₂H₅)₃, P(C₃H₇)₃, P(C₄H₉)₃, P(C₆H₁₁)₃; C₂H₅-O-C₂H₅, CH₃-O-C₄H₉, CH₃O-(CH₂)₂-OCH₃, C₂H₅O-(CH₂)₂-OC₂H₅, CH₃-S-CH₃, C₂H₅₋S-C₂H₅, C₃H₇-S-C₃H₇, Ph-S-Ph, CH₃S-(CH₂)₂-SCH₃, CH₃S-(CH₂)₃-SCH₃, C₂H₅S-(CH₂)₂-SC₂H₅ and PhS- (CH₂)₂-SPh.

9. Compounds of the general formula (I)
di{[bis(trimethylsilyl)acetylene]copper(I)} oxalate,
di{[(trimethylsilyl)(n-butyl)acetylene]copper(I)} oxalate,
di[(vinyl-t-butyldimethylsilane)copper(I)] oxalate,
di[(vinyldiethylmethylsilane)copper(I)] oxalate.

10. A process for preparing the compounds of the general formula (I) according to claims 1-9, **characterized in that** Cu₂O is reacted with oxalic acid and a Lewis base L in an inert solvent and the resultant product is isolated.

11. A process according to claim 10, **characterized in that** an inert aprotic organic solvent is used which is an open-chain or cyclic aliphatic or aromatic hydrocarbon, a halogenated aliphatic or halogenated aromatic hydrocarbon or a linear or cyclic ether or a mixture of these hydrocarbons.

12. A process according to claim 10 or claim 11, **characterized in that** a solvent selected from the group consisting of pentane, hexane, heptane, cyclohexane, toluene, methylene chloride, trichloromethane, chlorobenzene, diethyl ether and tetrahydrofuran is used.

13. A process according to claim 10, **characterized in that** it is carried out under a protective-gas atmosphere.

14. A process according to claim 13, **characterized in that** the protective gas employed is nitrogen or argon.

15. A process according to claim 10, **characterized in that** the Lewis base L is employed in excess relative to the stoichiometric ratio of the starting materials Cu₂O and oxalic acid, but at least in twice the stoichiometric ratio.

16. A process according to either of claims 10 and 15, **characterized in that** the starting materials Cu₂O, oxalic acid and Lewis base L are employed in a stoichiometric ratio of from 1:1:2 to 1:1:4.

17. A process according to one or more of claims 10, 15 and 16, **characterized in that** two different Lewis bases L are employed in identical molar amounts.

18. A process according to one or more of claims 10 to 17, **characterized in that** the reaction is carried out within a reaction time of from 1 to 24 hours at a temperature in the range from -30 to +100°C.

19. A process according to one or more of claims 10 to 18, **characterized in that** it is carried out at room temperature.

20. A process according to one or more of claims 10 to 19, **characterized in that**, when the reaction has ended, insoluble constituents are separated off and the reaction product is isolated from the solution and, if appropriate, purified, or **in that** the reaction product is extracted from the reaction mixture, isolated and, if appropriate, purified.

21. A process according to one or more of claims 10 to 19, **characterized in that** insoluble constituents are separated off by filtration.

22. The use of the compounds of the general formula (I) according to claims 1 to 9 for producing high-purity thin layers of copper metal.

23. A process for producing high-purity thin layers of copper metal, **characterized in that** compounds of the general formula (I) according to claims 1 to 9 are heated whereby the Lewis base L is detached and metallic copper is deposited through decarboxylation.

24. A process according to claim 23, **characterized in that** the detachment of the Lewis base L is effected at a temperature in the range from 50 to about 200°C and the decarboxylation to form metallic copper is concluded at a temperature in the range from 150 to 350°C.

25. A process according to claims 23 to 24, **characterized in that** the detached Lewis base L is recycled, re-employed in a process according to claims 10 to 21 and used for producing high-purity thin metallic layers of copper.

## Revendications

1. Composés de la formule générale (I) : 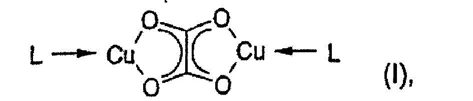 dans laquelle le cuivre présente le degré d'oxydation +1, et
L représente R-C≡C-R' avec au moins un groupe silyle ou ester, R'HC=CHR avec au moins un groupe silyle ou ester, R'₃Si-C≡C-R', R'₃N, R'₂N(CH₂)ₙNR'₂, de la 2,2'-bipyridine substituée ou non substituée, de la 1,10-phénanthroline, P(OR')₃, P(alkyle)₃, R'-O-R', R'-O(CH₂)ₙO-R', R'-S-R', R'-S(CH₂)ₙS-R'
ou un nitrile du groupe CH₃-C≡N, ^{t}Bu-C≡N, C₄H₉C≡N et Ph-C≡N,
où
R représente un radical A, aryle, alkylaryle ou alcynyle avec au moins un groupe SiR'₃ ou COOR', et
R' représente un radical R, H, A, aryle, alkylaryle ou alcynyle,
L, R et R' pouvant, indépendamment l'un de l'autre, adopter des significations identiques ou différentes dans différentes positions de la molécule,
et
A représente un radical alkyle en C1-C30 linéaire ou ramifié, cycloalkyle en C3-C30, alcényle en C2-C30 linéaire ou ramifié, cycloalcényle en C3-C30 linéaire ou ramifié,
aryle représente des groupes aryle en C6-C10, alkylaryles,
alkylaryle représente des groupes alkylaryle en C7-C18,
alcynyle représente un groupe alcynyle en C2-C30 linéaire ou ramifié.

2. Composés suivant la revendication 1, dans lesquels
A représente un groupe alkyle en C1-C9 linéaire ou ramifié, cycloalkyle en C3-C9 linéaire ou ramifié, alcényle en C2-C9 linéaire ou ramifié, cycloalcényle en C3-C9 linéaire ou ramifié,
aryle signifie phényle, naphtyle,
alkylaryle signifie toluyle ou mésityle,
alcynyle représente des groupes alcynyle en C2-C9 linéaires ou ramifiés,
et R et R' peuvent, indépendamment l'un de l'autre, adopter des significations identiques ou différentes dans différentes positions de la molécule.

3. Composés suivant la revendication 1, dans lesquels
A représente des radicaux alkyle en C1-C4 linéaires ou ramifiés du groupe du méthyle, de l'éthyle, du n-propyle, du i-propyle, du n-butyle, du i-butyle et du tert-butyle, des radicaux cycloalkyle en C3-C6 du groupe du cyclopropyle, du cyclobutyle, du cyclopentyle et du cyclohexyle, des radicaux alcényle en C2-C6 linéaires ou ramifiés du groupe du vinyle, du propényle, du butényle, du pentényle et de l'hexényle, des radicaux cycloalcényle en C3-C6 du groupe du cyclopropényle, du cyclobutényle, du cyclopentényle, du cyclopentadiényle et du méthyl-cyclopentadiényle,
aryle signifie phényle, naphtyle,
alkylaryle signifie toluyle ou mésityle,
alcynyle représente des radicaux alcynyle en C2-C6 linéaires ou ramifiés du groupe de l'éthynyle, du propynyle, du butynyle, du pentynyle et de l'hexynyle,
et R et R' peuvent, indépendamment l'un de l'autre, adopter des significations identiques ou différentes dans différentes positions de la molécule.

4. Composés suivant la revendication 1, dans lesquels L représente R-C≡C-R' ou R'HC=CHR avec chaque fois au moins un groupe silyle ou ester, et les radicaux R et R' ont les significations données dans la revendication 1.

5. Composés suivant la revendication 1, dans lesquels
L représente R'₃Si-C≡C-R', où
R' représente SiMe₃, CH₃, C₂H₅, C₃H₇, C₄H₉, phényle, COOMe, COOEt.

6. Composés suivant la revendication 1, dans lesquels
L est un alcyne choisi parmi le groupe
Me₃Si-C≡C-SiMe₃, Me₃Si-C≡C-ⁿBu, MeOOC-C≡C-COOMe,
EtOOC-C≡C-COOEt et Me₃Si-C≡C-R', où R' représente CH₃, C₂H₅, C₃H₇, phényle, COOMe ou COOEt.

7. Composés suivant la revendication 1, dans lesquels L est un alcène choisi parmi le groupe H₂C=CHSiMe₃, H₂C=CHCOOCH₃, H₂C=CHCOOC₂H₅ et H₂C=CHSiR'₃, où R' représente indépendamment CH₃, C₂H₅, C₃H₇, C₄H₉, HC=CH₂, phényle.

8. Composés suivant la revendication 1, dans lesquels L est un composé choisi parmi le groupe CH₃-C≡N, ^{t}Bu-C≡N, C₄H₉C≡N, Ph-C≡N, N(CH₃)₃, N(C₂H₅)₃, H₂N-(CH₂)₂-NH₂, (CH₃)₂N-(CH₂)₂-N(CH₃)₂, (C₂H₅)₂N-(CH₂)₂-N(C₂H₅)₂, H₂N-(CH₂)₄-NH₂, (CH₃)₂N-(CH₂)₄₋N(CH₃)₂, (C₂H₅)₂N-(CH₂)₄-N(C₂H₅)₂, 2,9-diméthyl-1,10-phénanthroline, P(OCH₃)₃, P(OC₂H₅)₃, P(OC₆H₁₁)₃, P(OPh)₃, P(CH₃)₃, P(C₂H₅)₃, P(C₃H₇)₃, P(C₄H₉)₃, P(C₆H₁₁)₃, C₂H₅-O-C₂H₅, CH₃-O-C₄H₉, CH₃O-(CH₂)₂-OCH₃, C₂H₅O-(CH₂)₂-OC₂H₅, CH₃-S-CH₃, C₂H₅-S-C₂H₅, C₃H₇-S-C₃H₇, Ph-S-Ph, CH₃S-(CH₂)₂-SCH₃, CH₃S-(CH₂)₃-SCH₃, C₂H₅S-(CH₂)₂-SC₂H₅ et PhS-(CH₂)₂-SPh.

9. Composés de la formule générale (I) :
oxalate de di{[bis(triméthylsilyl)acétylène]cuivre(I)},
oxalate de di{[(triméthylsilyl)(n-butyl)acétylène]cuivre(I)},
oxalate de di[(vinyl-t-butyldiméthylsilane)cuivre(I)],
oxalate de di[(vinyldiéthylméthylsilane)cuivre(I)].

10. Procédé de préparation des composés de la formule générale (I) suivant les revendications 1 à 9, **caractérisé en ce qu'**on fait réagir Cu₂O avec de l'acide oxalique et une base de Lewis L dans un solvant inerte et on isole le produit préparé.

11. Procédé suivant la revendication 10, **caractérisé en ce qu'**on utilise un solvant organique aprotique inerte choisi parmi des hydrocarbures aliphatiques ou aromatiques à chaînes ouvertes ou cycliques, des hydrocarbures aliphatiques halogénés ou aromatiques halogénés ou des éthers linéaires ou cycliques ou des mélanges de ces hydrocarbures.

12. Procédé suivant l'une des revendications 10 et 11, **caractérisé en ce qu'**on utilise un solvant choisi parmi le groupe du pentane, de l'hexane, de l'heptane, du cyclohexane, du toluène, du chlorure de méthylène, du trichlorométhane, du chlorobenzène, de l'éther diéthylique ou du tétrahydrofuranne.

13. Procédé suivant la revendication 10, **caractérisé en ce qu'**il est effectué sous une atmosphère de gaz protecteur.

14. Procédé suivant la revendication 13, **caractérisé en ce que**, comme gaz protecteur, on met en oeuvre de l'azote ou de l'argon.

15. Procédé suivant la revendication 10, **caractérisé en ce que** la base de Lewis L est mise en oeuvre en excès par rapport aux proportions stoechiométriques des matières de départ Cu₂O et acide oxalique, et au moins dans un rapport stoechiométrique doublé.

16. Procédé suivant l'une des revendications 10 et 15, **caractérisé en ce que** les matières de départ Cu₂O, acide oxalique et base de Lewis L sont mises en oeuvre dans un rapport stoechiométrique de 1/1/2 à 1/1/4.

17. Procédé suivant une ou plusieurs des revendications 10, 15 et 16, **caractérisé en ce qu'**on met en oeuvre deux bases de Lewis L différentes en des quantités molaires identiques.

18. Procédé suivant une ou plusieurs des revendications 10 à 17, **caractérisé en ce que** la réaction est effectuée dans un intervalle de temps de 1 à 24 heures dans une gamme de températures de -30 à +100°C.

19. Procédé suivant une ou plusieurs des revendications 10 à 18, **caractérisé en ce qu'**il est mis en service à température ambiante.

20. Procédé suivant une ou plusieurs des revendications 10 à 19, **caractérisé en ce que**, la réaction achevée, on sépare des composants insolubles et on isole de la solution le produit réactionnel et éventuellement on le purifie, ou **en ce qu'**on sépare le produit réactionnel par extraction du mélange réactionnel, on l'isole et éventuellement on le purifie.

21. Procédé suivant une ou plusieurs des revendications 10 à 19, **caractérisé en ce qu'**on sépare des composants insolubles par filtration.

22. Utilisation des composés de la formule générale (I) suivant les revendications 1 à 9, pour la préparation de couches métalliques de cuivre minces, très pures.

23. Procédé de préparation de couches métalliques de cuivre minces, très pures, **caractérisé en ce qu'**on chauffe des composés de la formule générale (I) suivant les revendications 1 à 9, ce qui donne lieu à une élimination de la base de Lewis L et à un dépôt de cuivre métallique par décarboxylation.

24. Procédé suivant la revendication 23, **caractérisé en ce que** l'élimination de la base de Lewis L a lieu dans une gamme de températures de 50 à environ 200°C et la décarboxylation avec formation de cuivre métallique est achevée dans une gamme de températures de 150 à 350°C.

25. Procédé suivant les revendications 23 et 24,
**caractérisé en ce que** la base de Lewis L éliminée est recyclée, est à nouveau mise en oeuvre dans un procédé suivant les revendications 10 à 21, et est utilisée pour la préparation de couches métalliques de cuivre minces, très pures.
